# EUROPÄISCHE PATENTSCHRIFT

(11) **EP 1 778 477 B1**
(45) Veröffentlichungstag und Bekanntmachung des Hinweises auf die Patenterteilung: **07.04.2010**
(21) Anmeldenummer: 05758415.3
(22) Anmeldetag: 30.06.2005
(51) Int. Cl.: B32B 17/10

(54) **ELEMENT MIT EINER VIELZAHL VON LEUCHTDIODEN**
ELEMENT COMPRISING A PLURALITY OF LIGHT-EMITTING DIODES
ELEMENT COMPORTANT UNE PLURALITE DE DIODES ELECTROLUMINESCENTES

(30) Priorität: 17.08.2004 DE 102004039897
(43) Veröffentlichungstag der Anmeldung: 02.05.2007
(73) Patentinhaber: Schott AG, 55122 Mainz (DE)
(72) Erfinder: SCHMITZ, Thomas, 55278 Hahnheim (DE); SCHILLERT, Horst, 31073 Grünenplan (DE); BIETHMANN, Stefan, 91487 Vestenbergsgreuth (DE); NICKUT, Andreas, 31073 Delligsen (DE); LÜDEKE, Rüdiger, 31061 Alfeld (DE); ANTON, Matthias, 37632 Eimen (DE); SCHNEIDER, Rolf, A., O., 72108 Rottenburg (DE); DÖPPNER, Christoph, Lothar, 36124 Eichenzell-Lütter (DE)
(74) Vertreter: Sawodny, Michael-Wolfgang
(86) Internationale Anmeldenummer: PCT/EP2005/007026
(87) Internationale Veröffentlichungsnummer: WO 2006/018066

(56) Entgegenhaltungen:
- EP-A- 1 346 822
- EP-A- 1 437 215
- WO-A-2004/106056
- DE-A1- 10 019 888

## Beschreibung

Die Erfindung betrifft ein Element, vorzugsweise ein transparentes Element, das wenigstens ein erstes transparentes und ein zweites, vorzugsweise transparentes Substrat sowie wenigstens einen elektrischen Verbraucher aufweist.

Neben Fenstern gibt es eine Vielzahl weiterer Anwendungsbereiche für transparente Elemente, beispielsweise großflächige Glasfronten an Gebäuden, Schaufenstern, Gebäudedachelemente, Türen, Treppen, Abtrennungen, Vitrinen, Möbel, Geländer, Verkleidungen wie zum Beispiel Tunnelverkleidungen, Wand - und Deckenverkleidungen, sowie ein künstlicher Himmel..

Aus der EP 0900971 A1 ist bekannt, auf einer Glasplatte Leuchtdioden zu befestigen, die über dünne und transparente Leiterbahnen mit Strom versorgt werden.

Die EP 0593940 A1 beschreibt eine Verbundglasscheibe mit einem eingelagerten Draht, der vom Rand der Scheibe her kontaktiert ist, wobei ein Steckkontakt auf der Glasfläche angeordnet ist.

Die US 5105303 zeigt eine Verbundscheibe mit einer elektrochromatischen Zwischenschicht und die US 410398 zeigt eine Verbundscheibe mit einer in der Zwischenschicht eingelagerten elektrischen Heizung.

Die US 5533289 beschreibt ein zwischen zwei Scheiben eingelagertes elektrolumineszentes Element.

Im Stand der Technik ist bei einem transparenten Element, bestehend aus wenigstens einer ersten Scheibe und wenigstens einer zweiten Scheibe, die vorzugsweise transparent sind, eine der beiden Scheiben mit einer transparenten, leitfähigen Schicht versehen. Auf dieser Schicht sind die Verbraucher angeordnet. Die zweite Scheibe weist keine derartige leitfähige transparente Schicht auf und fungiert lediglich als Deckschicht. Die Leuchtmittel liegen dann geschützt zwischen der ersten Scheibe und der zweiten Scheibe. Ein derartiges transparentes Element ist beispielsweise aus der DE-A-10019888 bekannt geworden.

Nachteilig an einem Bauelement gemäß der DE-A-10019888 ist, dass die Leistungsaufnahme der leitfähigen Schicht die Anzahl der auf der Schicht anordenbaren Verbraucher und damit auch die Leuchtdichte je Flächeneinheit begrenzt.

EP 1 346 822 offenbart ein Gebäudedachelement, das zwei transparente Scheiben aufweist. Eine der beiden Scheiben ist mit einer Isolierglasscheibe verklebt. Ein Leuchtmittel ist in der Mittelscheibe integriert. Die Stromzufuhr für das Leuchtmittel ist durch eine elektrisch leitende Schicht angebracht.

Aufgabe der Erfindung ist es, die Nachteile des Standes der Technik zu überwinden, insbesondere soll ein transparentes Element zur Verfügung gestellt werden, bei dem die Anzahl der Verbraucher gegenüber den bisher aus dem Stand der Technik bekannten Lösungen erhöht werden kann.

Bevorzugt sind das erste transparente Substrat und das zweite transparente Substrat, Scheiben vorzugsweise Glasscheiben.

Bevorzugt ist es, dass die Leiterbahnen auf der ersten und der zweiten Scheibe, die ein transparentes Element ausbilden, so angeordnet sind, dass beim Verbinden der beiden Scheiben keine Überdeckung entsteht, da dies ansonsten zu einem Kurzschluss führen würde bzw. aufwändige Isoliermaßnahmen erforderlich wären.

Bevorzugt sind die Leiterbahnen auf der ersten Scheibe bezüglich der Leiterbahnen auf der zweiten Scheibe asymmetrisch angeordnet.

Neben einer Anordnung von Leiterbahnen auf zwei gegenüberliegenden Substraten, insbesondere Scheiben ist es auch möglich mehrere Substrate hintereinander in einem Stapel anzuordnen. Die Leiterbahnen sind bei einer derartigen Ausführungsform dann nicht gegenüberliegend sondern hintereinanderliegend angeordnet.

Vorteilhafterweise ist es bei hintereinander angeordneten Substraten auch möglich, mehr als zwei Substrate anzuordnen, beispielsweise drei, vier, fünf Substrate etc. Die Anzahl der Substrate ist nicht beschränkt, beispielsweise wäre auch die Anordnung von 100 Substraten hintereinander möglich.
Sind die Substrate hintereinander angeordnet, so sind die Leiterbahnen der einzelnen Substrate vorzugsweise versetzt zueinander angeordnet.

In einer weiteren bevorzugten Ausgestaltung der Erfindung sind die zu einem Verbund miteinander verbundenen Scheiben lösbar miteinander verbunden. Dies ermöglicht es, dass die Scheiben des vorzugsweise transparenten Elementes nach Zusammenbau zu einem transparenten Element auch voneinander gelöst werden können, so dass die zwischen den Scheiben, vorzugsweise den transparenten Scheiben liegenden Verbraucher, insbesondere Leuchtdioden, zugänglich sind und getauscht werden können.

In einer weiteren bevorzugten Ausgestaltung der Erfindung kann das transparente Element als Isolierglasverbund, beispielsweise mit einer umlaufenden Rahmendichtung, aufgebaut sein. Die Rahmendichtung ist bevorzugt aus Aluminium. Eine derartig umlaufende Rahmendichtung lässt sich beispielsweise mit einem Messersystem lösen. Auf diese Art und Weise können die Scheiben voneinander abgehoben werden und die Verbraucher, insbesondere die Leuchtdioden, die beispielsweise zwischen erster und zweiter Scheibe angeordnet sind, sind zugänglich. Ein defekter Verbraucher kann dann beispielsweise von der ersten transparenten Scheibe, auf der er angeordnet ist, entfernt werden, beispielsweise indem er abgelötet wird. Nachdem der Verbraucher von der transparenten Scheibe, auf der er angeordnet ist, abgelöst wurde, kann er gegen einen neuen Verbraucher ersetzt werden.

Der Isolierglasverbund kann sowohl mit oder ohne eine Schutzgasfüllung ausgeführt sein.

Alternativ zu einem lsolierglasverbund mit einer umlaufenden Rahmendichtung ist es auch möglich, dass das transparente Element aus verschiedenen Scheiben einen sogenannten Einfachverbund darstellt, bei dem beispielsweise mit Hilfe von Distanzelementen bei einem Verbund beispielsweise aus zwei Scheiben die erste transparente Scheibe zu der zweiten transparenten Scheibe auf Distanz gehalten wird. Der Einfachverbund kann beispielsweise durch ein Klammerrahmensystem zusammengehalten werden. Wird das Klammerrahmensystem geöffnet, so lassen sich die erste transparente Scheibe und die zweite transparente Scheibe einfach trennen. Durch Lösen der Klammern des Klammerrahmensystems kann das transparente Element geöffnet werden, so dass ein defekter Verbraucher, beispielsweise eine LED ersetzt werden kann.

Alternativ zu den beschriebenen Elementen mit Rahmensystemen ist es auch möglich, die verschiedenen transparenten Scheiben, beispielsweise bei einem Zwei-Scheiben-System die erste transparente Scheibe mit der zweiten transparenten Scheibe mit einem Verbindungsmaterial beispielsweise durch Gießharz oder einer Folie oder einem thermoplastischen Material oder Wachs zu verbinden.

Ist das Verbindungsmaterial Gießharz, so ist eine sehr hohe Temperatur beispielsweise größer als 200 °C erforderlich, um das Gießharz zum Schmelzen zu bringen. Bei diesen Temperaturen werden aber die Leuchtdioden zerstört, so dass ein Lösen des Verbundes durch Schmelzen praktisch nicht möglich ist. Ein solcher Verbund wird daher im Rahmen dieser Anmeldung als "fester Verbund" bezeichnet.

Wird aber ein thermoplastisches Material oder Wachs als Verbindungsmaterial zwischen erstem und zweitem transparenten Element verwandt, so ist es möglich, bei Temperaturen kleiner als beispielsweise 100°C das Verbindungsmaterial aufzuschmelzen. Bei diesen Temperaturen erleiden die Leuchtmittel keinen Schaden. Daher kann das transparente Element, bestehend aus einer ersten transparenten Scheibe und einer zweiten transparenten Scheibe mit einem thermoplastischen Material oder Wachs im Sinne dieser Anmeldung gelöst werden und der Verbraucher bzw. die Leuchtdiode wird freigelegt, so dass sich defekte Elemente wechseln lassen. Ein derartiger Verbund ist im Rahmen dieser Anmeldung somit ein "lösbarer Verbund".

In einer alternativen Ausführungsform der Erfindung ist es auch möglich, dass mehrere Scheiben, beispielsweise bei einem Verbund aus zwei Scheiben die erste transparente Scheibe und die zweite transparente Scheibe am Rand durchbohrt sind und beispielsweise mittels Schrauben direkt miteinander verbunden werden. Am Rand der ersten und zweiten Scheibe kann eine Dichtung eingelegt werden. Die Dichtung dient auch als Distanzelement. Eine derartige lösbare Befestigung ist auch möglich bei einem Stapel aus hintereinander angeordneten Substraten bzw. Scheiben.

Um die Verbraucher bzw. die Leuchtdioden zwischen der Vielzahl von hintereinander angeordneten Scheibe anordnen zu können, kann, falls der Abstand zwischen erster und zweiter Scheibe nicht ausreichend ist, vorgesehen sein, dass beide transparenten Substrate mit sogenannten Sacklöchern versehen sind, die die Verbraucher aufnehmen. Durch eine derartige Ausführungsform kann die Bauhöhe des gesamten Bauelementes ganz entscheidend verringert werden.

Neben der Lösung der erfindungsgemäßen Aufgabe mit Hilfe von mehreren, insbesondere zwei miteinander verbundenen transparenten Substraten, ist es auch möglich, die beiden Scheiben fest im Sinne dieser Anmeldung miteinander zu verbinden, beispielsweise mittels eines Gießharzes. Im Falle eines festen Verbundes können bei einem Verbund aus zwei Substraten beide Scheiben, mit Bohrlöchern versehen werden. Bei der Herstellung des Verbundes werden die Verbraucher bzw. Leuchtdioden in die entsprechenden Bohrungen eingelassen.

Die Verbraucher liegen dann bei der Herstellung des Verbundes frei und können jederzeit gewechselt werden. Um die Verbraucher bzw. Leuchtdioden zu schützen, ist es möglich, anschließend an die Herstellung des Verbundes die Bohrlöcher mit einer Vergussmasse zu versehen. Wird der Verbraucher bzw. die Leuchtdiode gewechselt, so wird die Vergussmasse entfernt und der Verbraucher erneuert und anschließend neu versiegelt.

In einer besonders bevorzugten Ausführungsform ist vorgesehen, dass bei einem Element oder Verbund aus zwei Scheiben beide Scheiben Durchbohrungen aufweisen. Die Leuchtdiode wird dann beispielsweise in einem wasserhellen Kunststoffstopfen integriert und zusammen mit dem Stopfen in die Bohrung, beispielsweise der zweiten Scheibe, gepresst. Weist die erste Scheibe eine elektrisch leitende, leitfähige Schicht auf, so wird durch das Einpressen des Kunststoffstopfens in die Bohrung diese Schicht in eine elektrisch leitende Verbindung mit dem Verbraucher, hier der Leuchtdiode (LED), gebracht.

Die Erfindung soll nachfolgend anhand der Zeichnungen näher beschrieben werden.

Es zeigen:
- Fig. 1a - 1c:: Ausführungsformen der Erfindung mit einer ersten Scheibe und einer zweiten Scheibe, wobei die erste Scheibe mit der zweiten Scheibe lösbar verbunden ist.
- Fig. 2:: transparente Scheibe mit einer leitfähigen Schicht.
- Fig. 3a - 3d:: Verfahren zur Strukturierung der leitfähigen Schicht.
- Fig. 4:: Ausführungsform der Erfindung mit einer ersten Scheibe, einem Verbundmaterial zwischen erster und zweiter Scheibe, wobei im Verbundmaterial der Verbraucher angeordnet ist.
- Fig. 5:: Ausführungsform der Erfindung mit einer ersten Scheibe und einer zweiten Scheibe und einem Verbraucher, der in einem Sackloch der gegenüberliegenden Scheibe angeordnet ist.
- Fig.6:: eine erste Ausführungsform der Erfindung mit Leuchtdioden, die zwischen zwei vorzugsweise transparenten Substraten angeordnet sind.
- Fig 7:: Draufsicht auf das erste transparente Substrat und das gegenüberliegende zweite transparente Substrat
- Fig 8:: Stapel aus mehr als zwei hintereinander angeordneten transparenten Substraten, wobei mindestens zwei Substrate Leiterbahn aus einer elektrisch leitfähigen Schicht zur Versorgung der Leuchtmittel umfassen.

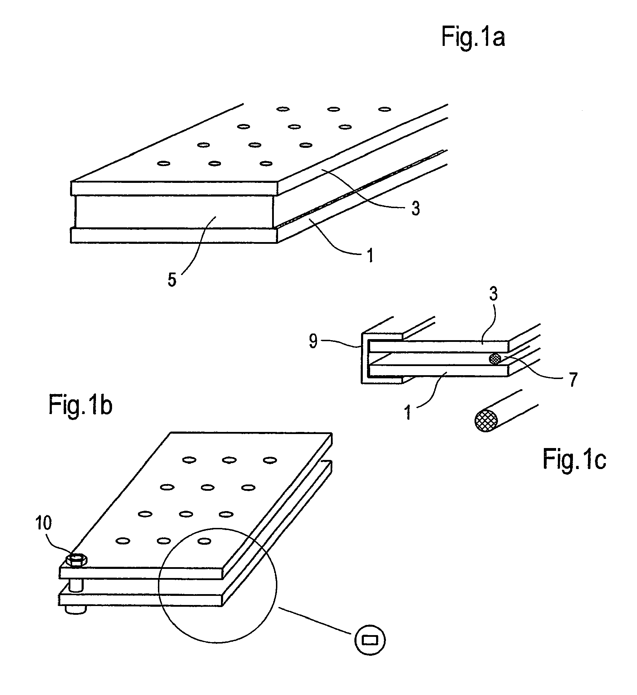

In den Figuren 1a bis 6 wird die Erfindung ohne Beschränkung hierauf anhand von Ausführungsbeispielen für ein System mit zwei transparenten Substraten beschrieben, wobei jedes der transparente Substrate Leiterbahnen zur Versorgung der Leuchtmittel umfasst.

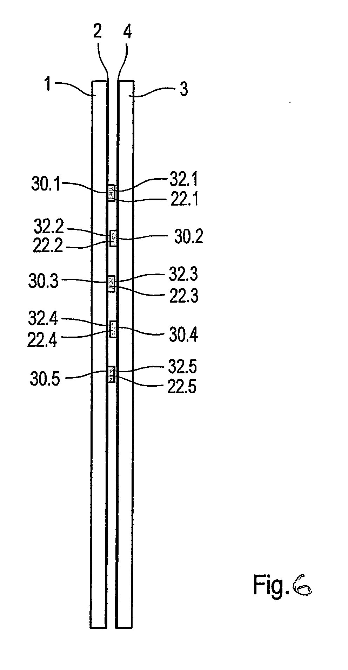

Das in den Figuren 1a - 1c gezeigte erfindungsgemäße transparente Element besteht wenigstens aus einer ersten transparenten Scheibe 1 und einer zweiten transparenten Scheibe 3. Die erste transparente Scheibe 1 ist mit der zweiten transparenten Scheibe 3 lösbar verbunden. Beispielsweise zeigt das Ausführungsbeispiel gemäß Figur 1a ein sogenanntes Verbundglaselement, das ein umlaufendes Rahmenelement 5 umfasst. Im Zwischenraum zwischen erstem und zweitem transparenten Substrat sind die elektrischen Verbraucher, hier die Leuchtdioden, angeordnet. Das Rahmenelement 5 kann beispielsweise mittels eines Messers gelöst und so die erste transparente Scheibe 1 von der zweiten transparenten Scheibe 3 getrennt werden. Die im Zwischenraum angeordneten Verbraucher bzw. Leuchtmittel sind dann frei zugänglich und können getauscht werden. Im Schnitt ist ein derartiges Bauelement detailliert in Figur 6 gezeigt. Auf die Beschreibung dort wird verwiesen.

Wie dargestellt sind in einer vorteilhaften Ausführungsform beide Substrate, d. h. das erste Substrat 1 transparent, ebenso wie das zweite Substrat 3. Alternativ kann auch nur ein Substrat, beispielsweise das erste Substrat 1 transparent sein und das zweite Substrat intransparent, d. h. lichtundurchlässig. Unter transparent wird in dieser Anmeldung verstanden, dass das Substrat oder die Scheibe eine Transmission von mehr als 70 % im sichtbaren Wellenlängenbereich besitzt. Unter intransparent wird in dieser Anmeldung verstanden, dass das Substrat oder die Scheibe eine Transmission von weniger als 50 % im sichtbaren Wellenlängenbereich besitzt.

Figur 1b zeigt einen Einfachverbund, bei dem die erste transparente Scheibe 1 mit der zweiten transparenten Scheibe 3 mit Hilfe eines Verbindungsmittels, beispielsweise einer Schraube 10, lösbar verbunden sind und die erste transparente Scheibe und die zweite transparente Scheibe mit Hilfe einer Dichtung 7 auf Abstand gehalten wird.

Figur 1c zeigt einen ähnlichen Aufbau wie Figur 1b..Bei der Ausführungsform gemäß Figur 1c wird der Verbund durch einen Klammerrahmen 9 zusammengehalten. Werden die Klammern des Klammerrahmens 9 gelöst, so können die beiden transparenten Scheiben 1, 3 voneinander getrennt werden. Die Verbraucher bzw. Leuchtdioden sind dann zum Auswechseln wieder frei zugänglich.

Erfindungsgemäß sind beide transparenten Scheiben mit transparenten, elektrisch leitenden Bahnen zur Versorgung der Verbraucher versehen. Diese können aufgedampft werden, wie in der EP 0900971 A1 beschrieben, oder durch Strukturierung einer leitfähigen Schicht erhalten werden.

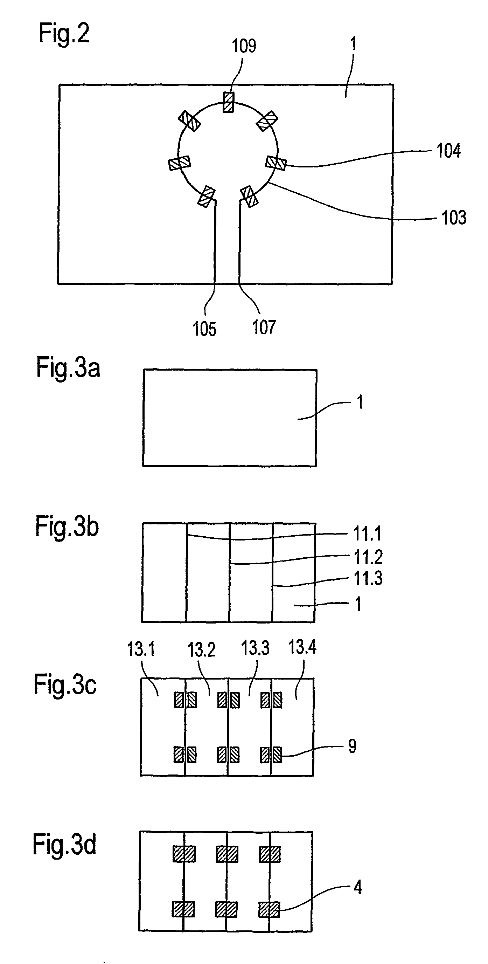

Die Strukturierung einer solchen leitfähigen Schicht ist in den Figuren 2 und 3a bis 3d beschrieben.

In Figur 2 ist eine der beiden transparenten Scheiben gezeigt, auf die eine leitfähige Schicht aufgebracht ist. Die leitfähige Schicht ist derart strukturiert, dass auf der transparenten Scheibe beispielsweise eine kreisförmige Leiterbahn 103 mit Anschlussleiter 105, 107 ausgebildet wird. Auf der kreisförmigen Leiterbahn 103 sind einzelne Anschlussstellen 109 angeordnet. Die Anschlussstellen 109 dienen dazu, die einzelnen Verbraucher, insbesondere Leuchtmittel, beispielsweise die Leuchtdioden 104 leitend mit einer Leiterbahn zu verbinden und damit die Energieversorgung der Leuchtdioden 104 sicherzustellen. Bevorzugt ist die transparente Scheibe ein Kalk-Natron Glas.

In den Figuren 3a bis 3d ist ein Verfahrensablauf zur Strukturierung einer der beiden transparenten Scheiben, die beispielsweise in einem erfindungsgemäßen transparenten Element Verwendung finden kann, dargestellt. Zunächst wird die transparente Scheibe 1 mit einer leitfähigen Schicht vollflächig beschichtet, beispielsweise im Sol-Gel-Verfahren.

Anschließend wird gemäß Figur 3b eine Strukturierung beispielsweise mittels Laser, der lokal die Beschichtung erhitzt und diese verdampft, hergestellt. Bevorzugt umfassen die Scheiben, die mit Hilfe eines Lasers strukturiert werden eine leitfähige Schicht, die im Bereich der Laserwellenlänge des eingesetzten Lasers eine hohe Absorption aufweisen und ein Material, welches bei dieser Wellenlänge transmissiv ist. Bei einem derartigen System weist die Glasschicht nur geringe Verletzungen auf. Insbesondere kann die Rissbildung bei derartigen Systemen weitgehend vermieden werden.

Die Kennlinien der einzelnen Bereiche des Substrates sind in Figur 3b mit den Bezugsziffern 11.1 - 11.3 bezeichnet. An die Strukturierung gemäß Figur 3b anschließend werden in den Bereichen 13.1 - 13.4 einzelne Anschlussstellen, so genannte Anschlusspads 9 aufgebracht. Die Anschlusspads 9 umfassen eine leitende Paste oder Lack, beispielsweise Silberleitlack oder Silberpaste und wird mittels Siebdruck oder Schablonendruck auf das leitfähige Substrat aufgebracht und anschließend eingebrannt. Durch das Einbrennen kann gleichzeitig ein Vorspannen des transparenten Substrates, insbesondere des transparenten Glassubstrates erfolgen. Hierdurch wird eine hohe mechanische Festigkeit in einem einzelnen Verfahrensschritt erzielt.

Nach Aufbringen der Kontakte in den unterschiedlichen Bereichen 13.1 - 13.4 können diese, wie in Figur 3d dargestellt, mit einem Standardverfahren bestückt werden, indem beispielsweise Lötpaste auf die Anschlusspads 9, beispielsweise mittels Schablonendruck, aufgebracht wird. Die Leuchtdioden (LED's) 4 werden sodann auf die Scheibe aufgebracht, wobei ein Chip-Bonder verwendet werden kann, der die Leuchtdioden 4 vor dem Lötprozess auf der Scheibe befestigt. Nach Befestigen der einzelnen LED's wird die Scheibe 1 mit den darauf befestigten Leuchtdioden durch einen Reflow-Ofen geschickt oder durch ein Wellenlötbad.

In einem Ausführungsbeispiel der Erfindung wird als Scheibe ein Glassubstrat, typischerweise ein Kalk-Natron-Glas, mit einem fluordotierten Zinnoxid beschichtet.
Das Aufbringen der Beschichtung geschieht wie folgt:
Ein Kalk-Natron-Glas als transparentes Substrat wird auf 500°C erhitzt. Sodann wird das Glas mit Monobutylzinnchlorid und Flusssäure in Ethanol besprüht, wobei die Sprühlösung die nachfolgende

### Zusammensetzung aufweist:

| | |
|---|---|
| Monobutylzinnchlorid | 70% |
| Ethanol | < 30% |
| Flusssäure | 0,4% |

Nach dem Besprühen umfasst das Kalk-Natronglas eine transparente, fluordotierte Zinnoxid-Schicht.

Die Beschichtung wird sodann mit einem Laser aufgetrennt. Mit Hilfe eines Rakels wird per Siebdruck eine Silberleitpaste, z. B. Cerdec SP 1248 aufgebracht. Die Paste Cerdec 1248 wird in einem Durchlaufofen bei 140°C für 2 min angetrocknet und dann durch eine Vorspannanlage bei ca. 700°C für ein Kalk Natron-Glas eingebrannt und vorgespannt. Anschließend wird handelsübliche Lötpaste per Schablonendruck aufgetragen und mit Leuchtdioden bestückt, beispielsweise NSCW 100 Leuchtdioden der Fa. Nichia. Beim folgenden Reflowlöten wird für 2 min das bestückte Substrat auf 120° C vorgeheizt und anschließend für 5 Sek. auf 235° C erhitzt. Daran anschließend wird langsam abgekühlt.

Anstelle der leitfähigen strukturierten Schicht zur Versorgung der Verbraucher können auf das erste transparente Substrat auch einzelne Leiterbahnen aus transparentem leitfähigem Material zu den einzelnen Verbrauchern aufgedampft sein. Derartige aufgedampfte Leiterbahnen zu einzelnen der Verbraucher sind in der EP 0900971 A1 beschrieben. Der Offenbarungsgehalt dieser Schrift wird vollumfänglich in die vorliegende Schrift mit aufgenommen.

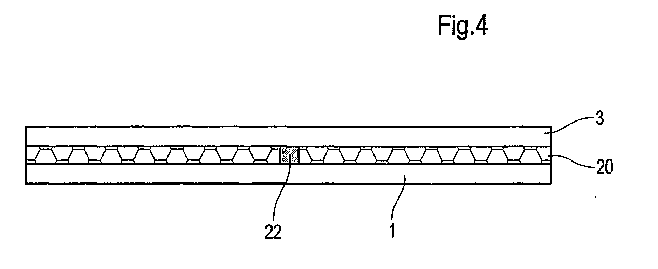

In den Figuren 4 bis 6 sind alternative Ausführungsformen der Erfindung gezeigt. In Figur 4 ist eine Ausführungsform der Erfindung gezeigt, bei der die erste Scheibe 1, die in der Regel eine transparente Scheibe ist, die die leitfähige Schicht trägt, mit der zweiten Scheibe 3, die in der Regel keine leitende Schicht trägt und als Deckglas fungiert, über ein Verbindungsmaterial, hier ein thermoplastisches Material 20 fest verbunden. Der Verbraucher ist im vorliegenden Fall eine Leuchtdiode 22, die zwischen erster Scheibe 1 und zweiter Scheibe 3 angeordnet ist.

Das thermoplastische Material 20 besitzt vorzugsweise einen Schmelzpunkt < 100°C. Durch Erwärmung des Gesamtverbundes kann dann die zweite Scheibe 3 von der ersten Scheibe 1 abgehoben werden. Die Leuchtdiode ist dann frei zugänglich und kann gegebenenfalls ausgewechselt werden. Nachdem die Leuchtdiode ausgewechselt ist, kann der Verbund wieder geschlossen werden.

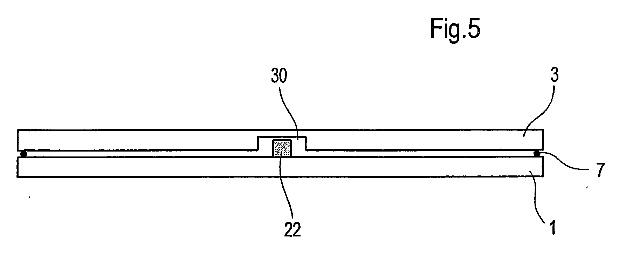

Figur 5 zeigt eine Ausführungsform der Erfindung, bei der in die zweite Scheibe 3, eine Vertiefung, ein so genanntes Sackloch 30 eingelassen ist. Die Leuchtdiode 22 ist im Sackloch 30 eingelassen. Auf diese Art und Weise ist es möglich, die Bauhöhe des transparenten Elementes gegenüber den zuvor dargestellten Ausführungsformen deutlich zu reduzieren.

Zwischen der zweiten Scheibe 3 und der ersten Scheibe 1 ist wiederum eine Dichtung 7 eingebracht. Die erste transparente Scheibe 1 und die zweite transparente Scheibe 3 können lösbar miteinander beispielsweise mit Hilfe einer Rahmenleiste oder von Verbindungsmitteln oder Klammern wie in den Figuren 1 a -1c dargestellt verbunden werden. Sowohl die erste Schicht wie die zweite Schicht weisen erfindungsgemäße Leiterbahnen für die Verbraucher, hier die Leuchtdioden auf. Die Leiterbahnen können entweder aufgedampft sein oder mittels Strukturierung einer vollflächigen Schicht hergestellt werden.

In Figur 6 ist eine Bauelement im Schnitt gezeigt, bei dem mehrere Leuchtdioden 22.1, 22.2, 22.3, 22.4, 22.5 zwischen einer ersten Scheibe 1 mit einer elektrisch leitenden, strukturierten Schicht und einer zweiten Scheibe 3 mit einer elektrisch leitenden strukturierten Schicht eingelassen sind. Die strukturierte Schicht weist Leiterbahnen auf, die assymmetrisch zueinander angeordnet sind. Die Leuchtdiode 22.1 wird von der Seite der ersten Scheibe 1 her versorgt, ebenso die Leuchtdioden 22.3 und 22.5. Die Leuchtdioden 22.2 und 22.4 werden von der Seite der zweiten Scheibe 3 her versorgt Die Leuchtdioden 22.1, 22.2, 22.3, 22.4, 22.5 haben ein Anschlussseite 30.1, 30.2, 30.3, 30.4, 30.5 mit der sie mit der elektrische leitenden Schicht verbunden sind und eine Abstrahlseite 32.1, 32.2, 32.3, 32.4, 32.5, die der Anschlussseite gegenüberliegt. Zwar strahlt die Leuchtdiode auch in Richtung der Anschlussseite 30.1, 30.2, 30.3, 30.4, 30.5 Licht ab, die Leuchtdichte beträgt jedoch weniger als 70% der Leuchtdichte der Leuchtdiode in Richtung der Abstrahlseite. Dies hat den Nachteil, dass bei einer Anordnung mit zwei Scheiben, bei denen die elektrisch leitenden Schichten sich gegenüberliegen wie in den Figuren 1a bis 6 gezeigt, die Leuchtdichte, wenn man das transparente Element von einer Seite her betrachtet, von Leuchtdiode zu Leuchtdiode schwankt, je nachdem ob die Leuchtdiode in Richtung der Anschlussseite oder der Abstrahlseite abstrahlt. Andererseits zeichnet sich eine solche Anordnung aber durch eine sehr kompakte Bauweise aus.

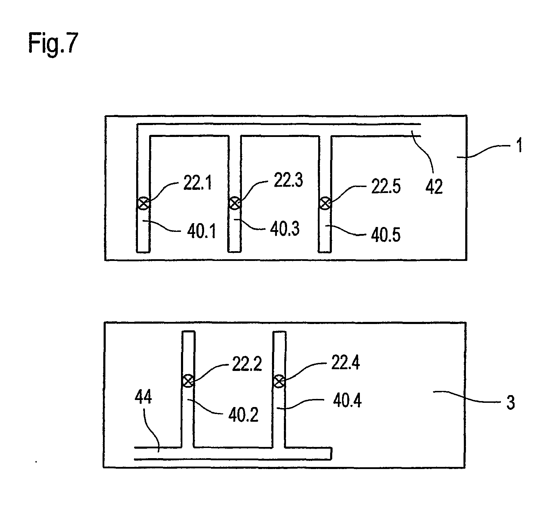

In Figur 7 ist eine Draufsicht auf das erste transparente Substrat 1 und das zweite transparente Substrat 3 eines Elementes gemäß Figur 6 gezeigt, wobei die Leiterbahnen 40.1, 40.2, 40.3, 40.4, 40.5 zu den einzelnen Leuchtdioden 22.1, 22.2, 22.3, 22.4, 22.5 gezeigt sind. Wie aus den Figuren zu entnehmen, sind die auf unterschiedlichen Substraten nebeneinander liegenden Leiterbahnen versetzt zueinander angeordnet, d.h. die Leiterbahn 40.1 auf Substrat 1 ist versetzt zur Leiterbahn 40.2. auf Substrat 3 angeordnet. Die Leiterbahn 40.2 auf Substrat 3 ist versetzt sowohl zur gegenüberliegenden Leiterbahn 40.1 wie zur Leiterbahn 40.3. Auch die elektrischen Zuleitungen 42, 44 auf den unterschiedlichen Substraten 1,3 sind versetzt zueinander angeordnet. Durch eine versetzte Anordnung wie in Figur 7 gezeigt ist es möglich auf eine Isolierung der Schichten gegeneinander zu verzichten, da durch die räumliche Distanz ein Kurzschluss sicher vermieden wird.

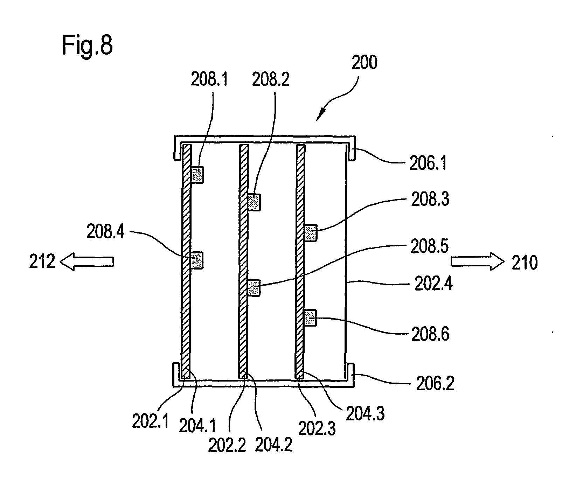

Eine gleichmäßige Leuchtdichte in einer Richtung wird erreicht, wenn alle Leuchtdioden in dieselbe Richtung abstrahlen. Ein entsprechendes Element 200 ist in Figur 8 gezeigt.

Beim Element 200 sind vier Substrate, hier vier transparente Scheiben 202.1, 202.2, 202.3 und 202.4 hintereinander angeordnet. Bei den transparenten Substraten 202.1, 202.2, 202.3 handelt es sich um Substrate, die mit Leiterbahnen 204.1, 204.2, 204.3 zu den jeweiligen Leuchtmitteln, hier Leuchtdioden 208.1, 208.2, 208.3, 208.4, 208.5, 208.6 versehen sind. Bei der transparenten Scheibe 202.4 handelt es sich um eine Deckscheibe des Elementes 200. Zusammengehalten wir das Element 200 durch Klammern 206.1, 206.2. Die Leuchtdioden 208.1, 208.2, 208.3, 208.4, 208.5, 208.6 sind auf den verschiedenen transparenten Substraten 202.1, 202.2, 202.3, 202.4 versetzt zueinander angeordnet, aber alle mit der Abstrahlseite in dieselbe Richtung, so dass sich in Richtung 210 eine höhere Leuchtdichte als in Richtung 212 ergibt. Die Leuchtdioden der verschiedenen Substrate können bei unterschiedlichen Wellenlängen Licht emittieren, so dass auch farbige Darstellungen möglich sind. Des weiteren können die Leuchtdioden auch einzeln angesteuert werden, wenn die Leiterbahnen zu den einzelnen Leuchtdioden einzeln aus dem Element 200 herausgeführt werden. Auf diese Art und Weise ist es möglich, z. B. laufende Bilder oder wechselnde Bilder zu erzeugen. Selbstverständlich sind bei Einzelansteuerung laufende Bilder oder wechselnde Bilder auch bei Elementen möglich mit zwei transparenten Substraten gemäß den Ausführungsformen in den Figuren 1a bis 7.

## Patentansprüche

1. Element, insbesondere Verbundglaselement, mit wenigstens einem ersten transparenten Substrat (1),
und wenigstens einem zweiten, vorzugsweise transparenten, Substrat (3), einem elektrischen Verbraucher, insbesondere einem Leuchtmittel (22), wobei das wenigstens erste transparente Substrat (1) wenigsten eine Leiterbahn oder eine elektrisch leitende Schicht aufweist und das wenigstens zweite, vorzugsweise transparente, Substrat (3) ebenfalls wenigstens eine Leiterbahn oder eine elektrisch leitende Schicht aufweist und die Leiterbahn oder die elektrisch leitende Schicht im wesentlichen transparent sind, mit der Maßgabe, dass der Fall, wonach Leuchtdioden als elektrische Verbraucher ohne Gehäuse direkt zwischen zwei leitenden Substraten kontaktieren, ausgenommen ist,
**dadurch gekennzeichnet, dass** die Leiterbahnen auf aufeinanderfolgenden Substraten versetzt zueinander angeordnet sind.

2. Element, insbesondere Verbundglaselement nach Anspruch 1,
**dadurch gekennzeichnet, dass** die Leiterbahnen durch Strukturierung der elektrisch leitenden Schicht erhalten werden.

3. Element, insbesondere Verbundglaselement nach Anspruch 1 oder 2, **dadurch gekennzeichnet, dass** die Leiterbahnen auf den einander gegenüberliegenden Seiten zweier Substrate asymmetrisch angeordnet sind.

4. Element nach einem der Ansprüche 1 bis 3, **dadurch gekennzeichnet, dass** das transparente Element mehr als zwei Substrate umfasst.

5. Element nach einem der Ansprüche 1 bis 4, **dadurch gekennzeichnet, dass** die Verbraucher Leuchtdioden (22) sind.

6. Element nach einem der Ansprüche 4 oder 5, **dadurch gekennzeichnet, dass** die Leuchtdioden (22) die jedem Substrat zugeordnet sind, verschiedene Wellenlängen abstrahien.

7. Element nach einem der Ansprüche 1 bis 6, **dadurch gekennzeichnet, dass** die Verbraucher von einer Steuereinrichtung einzeln oder zu mehreren angesteuert werden.

8. Element nach einem der Ansprüche 1 bis 7, **dadurch gekennzeichnet, dass** die transparenten Substrate des Elementes lösbar miteinander verbunden sind.

9. Element nach einem der Ansprüche 1 bis 7, **dadurch gekennzeichnet, dass** die Substrate des Elementes einen Isolierglasverbund ausbilden.

10. Element nach Anspruch 9, **dadurch gekennzeichnet, dass** der Isolierglasverbund eine lösbare Rahmendichtung (7) aufweist.

11. Element nach einem der Ansprüche 1 bis 7, **dadurch gekennzeichnet, dass** die Substrate des Elementes einen Einfachverbund ausbilden.

12. Element nach Anspruch 11, **dadurch gekennzeichnet dass** die Substrate des Einfachverbundes durch ein Klammerrahmensystem (206) lösbar miteinander verbunden sind.

13. Element nach einem der Ansprüche 1 bis 7, **dadurch gekennzeichnet, dass** die Substrate lösbar mit einem Verbundmaterial verbunden sind.

14. Element nach Anspruch 13, **dadurch gekennzeichnet, dass** das Verbundmaterial ein thermoplastisches Material oder ein Wachs ist.

15. Transparentes Element nach Anspruch 14, **dadurch gekennzeichnet, dass** am Rand zwischen erster Scheibe und Deckscheibe ein Dichtelement (7) eingelegt ist.

16. Transparentes Element nach einem der Ansprüche 1 bis 15, **dadurch gekennzeichnet, dass** das wenigstens eine Substrat des transparenten Elementes Sackbohrungen aufweist.

## Claims

1. An element, especially a laminated glass element, comprising at least a first transparent substrate (1) and at least a second, preferably transparent, substrate (3), an electric consumer, especially a lighting means (22), with the at least first transparent substrate (1) comprising at least one conductor path or an electrically conductive layer, and the at least second, preferably transparent, substrate (3) also comprising at least one conductor path or an electrically conductive layer and the conductor path or the electric conductive layer preferably being transparent, subject to the condition that the case is exempt according to which light-emitting diodes as electric consumers without housing make contact directly between two conductive substrates, **characterized in that** the conductor paths are arranged on successive substrates offset from one another.

2. An element, especially a laminated glass element according to claim 1, **characterized in that** the conductor paths are obtained by structuring of the electrically conductive layer.

3. An element, especially a laminated glass element according to claim 1 or 2, **characterized in that** the conductor paths are arranged in an asymmetric way on the sides of two substrates which are opposite of each other.

4. An element according to one of the claims 1 to 3, **characterized in that** the transparent element comprises more than two substrates.

5. An element according to one of the claims 1 to 4, **characterized in that** the consumers are light-emitting diodes.

6. An element according to one of the claims 4 or 5, **characterized in that** the light-emitting diodes (22) which are assigned to each substrate emit different wavelengths.

7. An element according to one of the claims 1 to 6, **characterized in that** the consumers are triggered individually or several at once by a control device.

8. An element according to one of the claims 1 to 7, **characterized in that** the transparent substrates of the element are detachably connected with each other.

9. An element according to one of the claims 1 to 7, **characterized in that** the substrates of the element form a laminated insulating glass.

10. An element according to claim 9, **characterized in that** the laminated insulating glass comprises a detachable frame seal (7).

11. An element according to one of the claims 1 to 7, **characterized in that** the substrates of the elements form a single lamination.

12. An element according to claim 11, **characterized in that** the substrates of the single lamination are joined to each other in a detachable manner by a clamping frame system (206).

13. An element according to one of the claims 1 to 7, **characterized in that** the substrates are detachably connected with a composite material.

14. An element according to claim 13, **characterized in that** the composite material is a thermoplastic material or a wax.

15. A transparent element according to claim 14, **characterized in that** a sealing element (7) is placed on the edge between first pane and cover pane.

16. A transparent element according to one of the claims 1 to 15, **characterized in that** the at least one substrate of the transparent element comprises blind holes.

## Revendications

1. Élément, en particulier élément en verre feuilleté, avec au moins un premier substrat transparent (1)
et au moins un deuxième substrat (3), de préférence transparent,
un consommateur électrique, en particulier une lampe (22), l'au moins un premier substrat transparent (1) comportant au moins une piste conductrice ou une couche conductrice électrique et l'au moins un deuxième substrat (3) de préférence transparent comportant également au moins une piste conductrice ou une couche conductrice électrique et la piste conductrice ou la couche conductrice électrique étant sensible transparent, en excluant le cas où des diodes électroluminescentes formant les consommateurs électriques viennent directement en contact entre deux substrats conducteurs sans boîtier,
**caractérisé en ce que** les pistes conductrices sont disposées sur des substrats successifs avec une décalage l'une par rapport à l'autre.

2. Élément, en particulier élément en verre feuilleté, selon la revendication 1, **caractérisé en ce que** les pistes conductrices sont obtenues en structurant la couche conductrice électrique.

3. Élément, en particulier élément en verre feuilleté, selon la revendication 1 ou 2, **caractérisé en ce que** les pistes conductrices sont disposées de façon asymétrique sur les faces opposées de deux substrats.

4. Élément selon l'une des revendications 1 à 3, **caractérisé en ce que** l'élément transparent comprend plus de deux substrats.

5. Élément selon l'une des revendications 1 à 4, **caractérisé en ce que** les consommateurs sont des diodes électroluminescentes (22).

6. Élément selon l'une des revendications 4 ou 5, **caractérisé en ce que** les Diodes électroluminescentes (22) associées à chaque substrat émettent dans une longueur d'onde différente.

7. Élément selon l'une des revendications 1 à 6, **caractérisé en ce que** les consommateurs sont commandés séparément ou à plusieurs par un dispositif de commande.

8. Élément selon l'une des revendications 1 à 7, **caractérisé en ce que** les substrats transparents de l'élément sont reliés entre eux de manière amovible.

9. Élément selon l'une des revendications 1 à 7, **caractérisé en ce que** les substrats de l'élément forment un feuilletage en verre isolant.

10. Élément selon la revendication 9, **caractérisé en ce que** le feuilletage en verre isolant présente un joint d'encadrement (7) amovible.

11. Élément selon l'une des revendications 1 à 7, **caractérisé en ce que** les substrats de l'élément forment un feuilletage simple.

12. Élément selon la revendication 11, **caractérisé en ce que** les substrats du feuilletage simple sont reliés entre eux de manière amovible par un système de cadre de serrage (206).

13. Élément selon l'une des revendications 1 à 7, **caractérisé en ce que** les substrats sont reliés de manière amovible avec un matériau d'assemblage.

14. Élément selon la revendication 13, **caractérisé en ce que** le matériau d'assemblage est une matière thermoplastique ou une cire.

15. Élément transparent selon la revendication 14, **caractérisé en ce qu'**un élément d'étanchéité (7) est inséré sur le bord entre la première plaque et la plaque de couverture.

16. Élément transparent selon l'une des revendications 1 à 15, **caractérisé en ce que** l'au moins un substrat de l'élément transparent présente des trous borgnes.
